# EUROPEAN PATENT APPLICATION

(11) **EP 4 654 463 A1**
(43) Date of publication of application: **26.11.2025**
(21) Application number: 25176316.5
(22) Date of filing: 14.05.2025
(51) Int. Cl.: H02P 27/08, G01R 31/00, G01R 31/42, H02P 29/024

(54) **POWER ELECTRONICS CONVERTER ASSESSMENT**

(30) Priority: 23.05.2024 GB 202407334
(71) Applicant: Rolls-Royce plc, London N1 9FX (GB)
(72) Inventor: Nadarajan, Sivakumar, Derby, DE24 8BJ (GB); Vaiyapuri, Viswanathan, Derby, DE24 8BJ (GB)
(74) Representative: Rolls-Royce plc

(57) **Abstract**

The disclosure relates to assessment of power electronics converters for electrical power systems. Example embodiments include a method of assessing a power electronics converter (102₁, 102₂) in an electrical propulsion system (100), the power electronics converter (102₁, 102₂) connected between a DC power supply (103₁, 103₂) and an AC electrical machine (101₁, 101₂) connected to a rotatable mechanical load (105, 203), the method comprising: i) operating the converter (102₁, 102₂) to drive the electrical machine (101₁, 101₂) to apply a torque to the mechanical load (105, 203); ii) recording a first set of electromagnetic emissions from the converter (102₁, 102₂); iii) comparing the first set of electromagnetic emissions with a second set of electromagnetic emissions to determine a difference between the first and second set of electromagnetic emissions; and iv) providing an assessment of the converter (102₁, 102₂) based on the difference between the first and second sets of electromagnetic emissions.

## Description

### CROSS REFERENCE TO RELATED APPLICATIONS

This represents the first application directed towards the subject-matter.

### FIELD

This disclosure relates to assessment of power electronics converters for electrical power systems.

### BACKGROUND

High power density power electronics converters are important components of power and propulsion systems for electric vertical take-off and landing (eVTOL) aircraft, hybrid electric aircraft and more generally aircraft having increasing levels of electric power systems, known commonly as 'more electric aircraft'. A power electronics converter comprises, among other things, high power semiconductor devices and capacitors. Component failures in such components can result from environmental and electrical stress. Such failures can be reduced by employing condition monitoring to identify and predict component degradation, which may for example be able to estimate the remaining useful life of each component.

In failures of power converters, capacitors and power semiconductor devices tend to contribute to a substantial proportion of total failures. Despite extensive efforts by manufacturers to improve the reliability of such components, together with implementation of cautious and conservative design methodologies, failures of power modules and capacitors may still occur due to wear-out caused by long term effects of electrical and environmental stress factors. Such failures are accelerated in demanding applications such as those in aerospace and defence sectors, and can lead to either shutdown of the whole electrical system or to severe performance degradation making the system unusable. Therefore, condition or health monitoring method that can track the health of a power converter and perform failure prognosis to assess future health is important in critical applications such as aerospace.

### SUMMARY

According to a first aspect there is provided a method of assessing a power electronics converter in an electrical propulsion system, the power electronics converter connected between a DC power supply and an AC electrical machine connected to a rotatable mechanical load, the method comprising:
i) operating the converter to drive the electrical machine to apply a torque to the mechanical load;
ii) recording a first set of electromagnetic emissions from the converter;
iii) comparing the first set of electromagnetic emissions with a second set of electromagnetic emissions to determine a difference between the first and second set of electromagnetic emissions; and
iv) providing an assessment of the converter based on the difference between the first and second sets of electromagnetic emissions.

The second set of electromagnetic emissions may be a pre-recorded set of electromagnetic emissions from a nominal power electronics converter.

The assessment may indicate a fault in the power electronics converter if the determined difference is greater than a predetermined level.

Where the power electronics converter is a first power electronics converter, the AC electrical machine a first AC electrical machine and the DC power supply a first DC power supply, the electrical propulsion system may further comprise a second power electronics converter connected between the second DC power supply and the second AC electrical machine, the second AC electrical machine connected to the rotatable mechanical load, wherein step i) comprises operating both first and second power electronics converters to drive the respective first and second electrical machines with equal and opposing torques.

The method may comprise recording the second set of electromagnetic emissions from the second power electronics converter.

The assessment may indicate a fault in the first or second power electronics converter if the determined difference is greater than a predetermined level.

Step iii) may comprise comparing a magnitude of emissions in a plurality of frequency bands in the first and second sets of electromagnetic emissions.

The assessment in step iv) may indicate a fault in the first power electronics converter if the magnitude of emissions in one or more of the plurality of frequency bands is greater in the first set of electromagnetic emissions by more than a predetermined threshold.

The assessment in step iv) may comprise an indication of remaining useful life of the power electronics converter.

Steps ii) to iv) may be carried out by a portable monitoring device comprising an antenna configured to receive the electromagnetic emissions from the converter.

According to a second aspect there is provided a monitoring device for assessing a power electronics converter in an electrical propulsion system, the power electronics converter connected between a DC power supply and an AC electrical machine connected to a rotatable mechanical load, the monitoring device comprising an antenna arranged to receive electromagnetic emissions from the power electronics converter, the monitoring device configured to:
i) record a first set of electromagnetic emissions from the converter via the antenna during operation of the electrical propulsion system;
ii) compare the first set of electromagnetic emissions with a second set of electromagnetic emissions to determine a difference between the first and second set of electromagnetic emissions; and
iii) provide an assessment of the converter based on the difference between the first and second sets of electromagnetic emissions.

The second set of electromagnetic emissions may be a pre-recorded set of electromagnetic emissions from a nominal power electronics converter.

The assessment may indicate a fault in the power electronics converter if the determined difference is greater than a predetermined level.

Where the power electronics converter is a first power electronics converter, the AC electrical machine a first AC electrical machine and the DC power supply a first DC power supply, the electrical propulsion system further comprising a second power electronics converter connected between the second DC power supply and the second AC electrical machine, the second AC electrical machine connected to the rotatable mechanical load, step i) may comprise operating both first and second power electronics converters to drive the respective first and second electrical machines with equal and opposing torques.

The monitoring device may be configured to record the second set of electromagnetic emissions from the second power electronics converter.

The assessment may indicate a fault in the first or second power electronics converter if the determined difference is greater than a predetermined level.

The monitoring device may be configured to compare a magnitude of emissions in a plurality of frequency bands in the first and second sets of electromagnetic emissions.

The assessment in step iv) may indicate a fault in the first power electronics converter if the magnitude of emissions in one or more of the plurality of frequency bands is greater in the first set of electromagnetic emissions by more than a predetermined threshold.

The assessment in step iv) may comprise an indication of remaining useful life of the power electronics converter.

### BRIEF DESCRIPTION OF THE DRAWINGS

Embodiments will now be described by way of example only with reference to the accompanying drawings, in which:
Figure 1 is a schematic diagram illustrating an example electrical power system with a portable power converter monitoring device;
Figure 2 is a schematic diagram of a multilane electrical propulsion system;
Figure 3 is a flow diagram illustrating an example method of assessing power electronics converters in an electrical propulsion system;
Figure 4 is a flow diagram illustrating an alternative example method of assessing power electronics converters in an electrical propulsion system;
Figure 5 is a schematic diagram of an example monitor for assessing a power electronics converter;
Figure 6 is an example plot of electromagnetic emissions from a first example converter; and
Figure 7 is an example plot of electromagnetic emissions from a second example converter.

### DETAILED DESCRIPTION

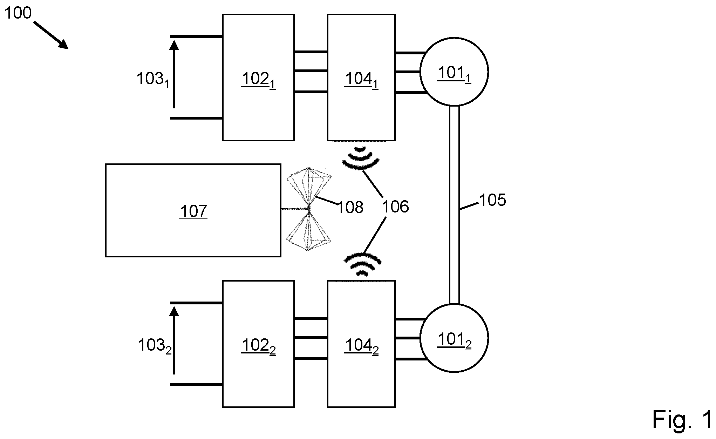

Figure 1 illustrates in schematic form an example electrical power system 100, which may for example comprise a propulsion system for an electric or hybrid electric aircraft. The system 100 comprises first and second electric machines 101₁, 101₂ driven as electric motors by respective first and second power electronics converters 102₁, 102₂, which in this example operate as inverters to convert respective first and second DC supplies 103₁, 103₂ to a three-phase AC output supply to the first and second electric machines 101₁, 101₂. First and second three phase current measurement modules 104₁, 104₂ are arranged to measure the currents provided to each of the phases of the respective first and second electric machines 101₁, 101₂. The first and second electrical machines 101₁, 101₂ are nominally identical and are connected to each other with a common drive shaft 105.

During operation, both converters 102₁, 102₂ emit electromagnetic (EM) noise 106. The level of EM emissions will tend to change when components in the converters 102₁, 102₂, such as semiconductor power devices or capacitors, degrade over time. A monitoring device 107 is equipped with an EM antenna 108 to receive the EM emissions 106 and measures the strength of the EM emissions over a predefined frequency range. The monitoring device 107, which may be portable, can assess the health of the power converters 102₁, 102₂ by comparing the strength of the EM emissions 106 with EM emissions from a new or known healthy power converter operating at the same load. The comparison may be made by either comparing EM emissions 106 from each converter 102₁, 102₂ with a recorded set of emissions from a nominal healthy converter or by comparing the emissions from each of the first and second converters 102₁, 102₂. The EM emissions 106 from the power converters 102₁, 102₂ will tend to change with load, so both converters 102₁, 102₂ should in the latter case be loaded equally to be able to accurately compare EM emissions.

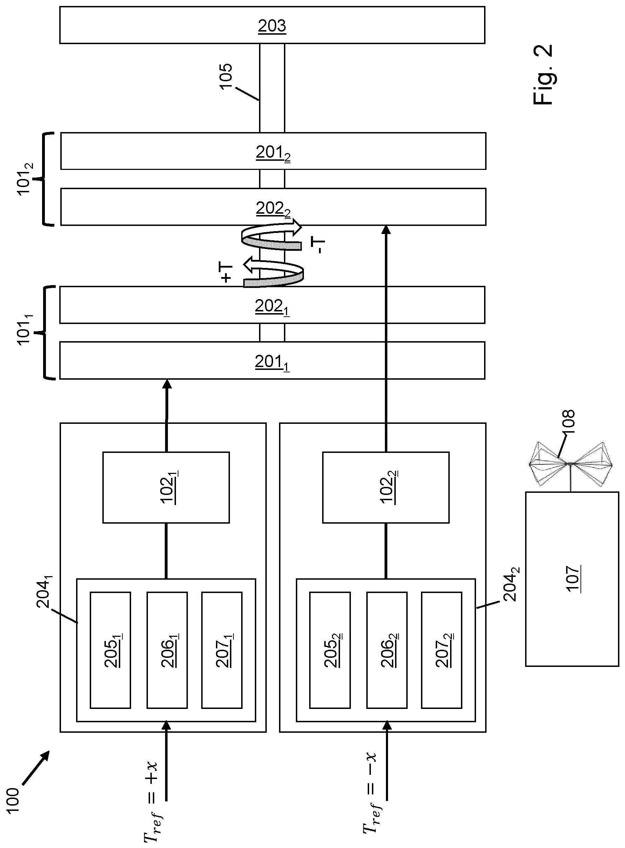

Figure 2 is a schematic block diagram of the electrical propulsion system 100, illustrating operation of the first and second electrical machines 101₁, 101₂ under the control of respective first and second controllers 204₁, 204₂. Under normal operation, the controllers 204₁, 204₂ control the electrical machines 101₁, 101₂ to operate together to drive a propulsor 203, which may be a propellor in the case of the system 100 being onboard an electric aircraft.

In a health assessment mode, a reference torque T_{ref} is set for the first and second converters 102₁, 102₂ at equal magnitudes and in opposite directions. An input control signal +x is provided to the controller 204₁ for the first converter 102₁ and an equal and opposite input control signal -x is provided to the controller 204₂ for the second converter 102₂. The controllers 204₁, 204₂ provide switching signals accordingly to the first and second converters 102₁, 102₂ to drive the first and second electrical machines 101₁, 101₂.

The electromagnetic torque +T produced by the rotor 202₁ relative to the stator 201₁ of the first electrical machine 101₁ and the electromagnetic torque -T produced by the rotor 202₂ relative to the stator 201₂ of the second electrical machine 101₂ are equal and opposite. The rotational speed of the propulsor 203 should therefore be zero, with the inverters 102₁, 102₂ both loaded to the same set reference torque. Loading the inverters 102₁, 102₂ without rotating the propulsor 203 allows the assessment to be safely performed during for example a prestart check, on-wing inspection, maintenance or during servicing of the system 100.

Each controller 204₁, 204₂ is programmed to operate the respective converter 102₁, 102₂ during the health assessment procedure, which is indicated in Figure 2 as shown in the form of a preprogrammed EHM test routine 205₁, 205₂ as an alternative mode to a normal EHM routine 206₁, 206₂. The EHM test routine 205₁, 205₂ can be triggered by operating a control switch 207₁, 207₂, for example during a prestart check or on-wing maintenance or inspection. While operating the EHM test routine 205₁, 205₂, the monitoring device 107 is in place to measure and record EM emissions from the first and second converters 102₁, 102₂.

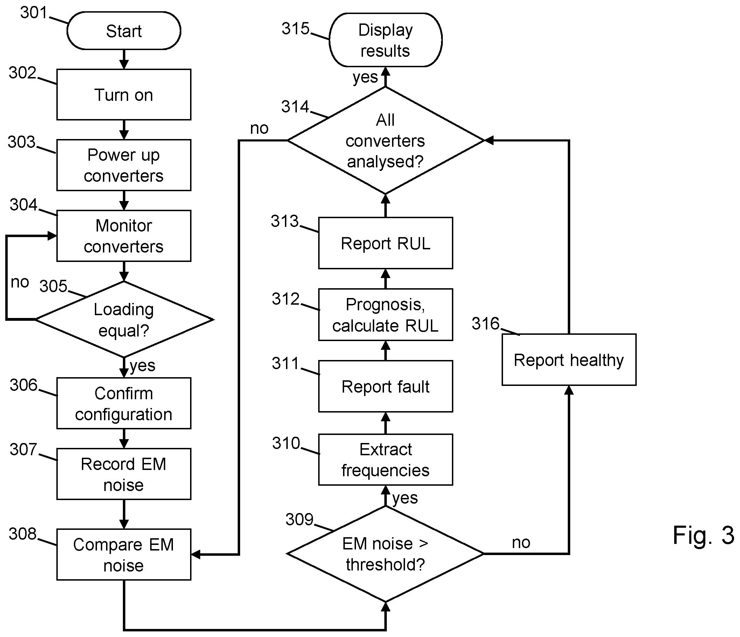

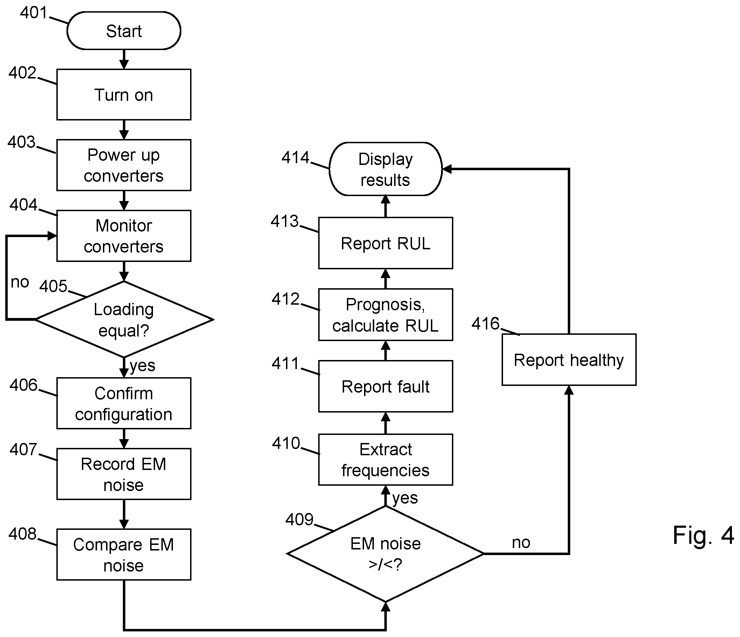

Figures 3 and 4 are flow diagrams illustrating example EHM test routines applied to the first and second controllers 204₁, 204₂ in combination with measurements of EM emissions made by the monitoring device 107. Figure 3 illustrates an example method of performing an EHM test routine by comparing EM emissions with prerecorded EM emissions from a known healthy converter, while Figure 4 illustrates an example method in which EM emissions from first and second converters are compared with each other to determine whether one converter may be faulty.

In the example method illustrated in Figure 3, the method starts at step 301 where the routine is started by triggering a prestart check or on-wing maintenance or inspection. At step 302 the monitoring device 107 is turned on. At step 303, the converters 102₁, 102₂ are powered up and instructed to deliver a set torque. At step 304 the converters 102₁, 102₂ are monitored to assess their loading and the speed of the propulsor 203. A check is made at step 305 to assess whether the converters 102₁, 102₂ are equally loaded and that the propulsor speed is zero. If not, the process repeats at step 304 until the required loading is achieved. At step 306, the monitoring device 107 is confirmed to be operating properly. At step 307 the monitoring device 107 records EM emissions from the converters 102₁, 102₂. The monitoring device 107 may be a portable device, which can be moved towards the electrical machines 101₁, 101₂ to monitor EM emissions from the converters 102₁, 102₂. Once a sufficient amount of EM emissions are recorded, at step 308 the monitoring device 107 compares the recorded EM emissions at selected different frequencies with pre-recorded EM emissions from a known healthy converter. If, at step 309, the EM emissions at any of the selected frequencies are greater than those from the prerecorded emissions or a preset threshold, the process proceeds to step 310 where the frequencies higher than the preset threshold are extracted and compared to the threshold. At step 311 a report is created indicating that the converter is faulty or degraded. The report may for example be transferred to a remote computer system. At step 312, which may be carried out at the remote computer system, a prognosis is performed based on analysing the recorded data, which may result in a calculation of remaining useful life (RUL) for the converter. The RUL may then be reported at step 313 to enable a decision to be made on any action. A technique such as linear regression may be used on collected data to determine an RUL for a converter by comparing the collected data to an expected lifetime based on accelerated testing of a similar converter.

If at step 309 none of the selected frequencies have emissions greater than the predetermined threshold, the process proceeds to step 316 where the converter is reported as being healthy and no action is required.

At step 314, the process returns to comparing EM emissions at step 308 if there are further converters to be analysed. If not, the process then completes at step 315 with the results being output, for example being displayed on the monitoring device or the remote computer system.

In some implementations, a single converter may be tested and steps 304 and 305 avoided by locking the electric motor with a brake to prevent rotation. The process may also be carried out individually for each lane in a multi-lane system.

In an example implementation, radiated emissions may be measured over a range of 150 kHz to 2 GHz and compared to a predetermined limit derived from a known healthy converter. If any of the measured radiated emissions exceed the predetermined limit, a fault may be reported. An example range of frequencies where peak emissions may occur may be generally between around 300 MHz and 600 MHz, within which range several peaks may typically be detected, the magnitude of which provide an indication of the state of the converter. In a particular example implementation, emission peaks were detected at around 324 MHz and 540 MHz.

In the alternative example method illustrated in Figure 4, the method proceeds similarly to that described above in relation to Figure 3 but instead of comparing recorded EM emissions with pre-recorded emissions from a known healthy converter, the emissions from first and second converters are compared with each other, and a fault identified if the emissions are significantly different. The process starts at step 401 where the routine is started by triggering a prestart check or on-wing maintenance or inspection. At step 402 the monitoring device 107 is turned on. At step 403, the converters 102₁, 102₂ are powered up and instructed to deliver a set torque. At step 404 the converters 102₁, 102₂ are monitored to assess their loading and the speed of the propulsor 203. A check is made at step 405 to assess whether the converters 102₁, 102₂ are equally loaded and that the propulsor speed is zero. If not, the process repeats at step 404 until the required loading is achieved. At step 406, the monitoring device 107 is confirmed to be operating properly. At step 407 the monitoring device 107 records EM emissions from both converters 102₁, 102₂. Once a sufficient amount of EM emissions are recorded, at step 408 the monitoring device 107 compares the recorded EM emissions at selected different frequencies from each of the converters 102₁, 102₂. If, at step 409, the EM emissions at any of the selected frequencies at the converters 102₁, 102₂ are different in magnitude, i.e., greater or smaller, than a predetermined threshold, the process proceeds to step 410 where the frequencies of one converter having magnitudes higher than those for the other converter are extracted and compared. At step 411 a report is created indicating that the converter with the higher EM emissions at the selected frequency or frequencies is faulty or degraded. The report may for example be transferred to a remote computer system. At step 412, which may be carried out at the remote computer system, a prognosis is performed based on analysing the recorded data, which may result in a calculation of remaining useful life (RUL) for the converter. The RUL may then be reported at step 413 to enable a decision to be made on any action.

If at step 409 the selected frequencies have emissions similar to each other, the process proceeds to step 416 where the converters are reported as being healthy and no action is required.

The process completes at step 414 with the results being output, for example being displayed on the monitoring device or the remote computer system.

An advantage of the alternative method in Figure 4 is that a multilane system can be tested to determine whether any of the converters is potentially faulty without the need for having a prerecorded set of EM emissions from a nominal converter, given that converters will be unlikely to degrade at exactly the same rate. An advantage of the method in Figure 3 is that an objective measure of **EM** emissions is used so that a test routine carried out at any time may be more likely to pick up a potentially faulty converter.

An advantage of both described methods is that no additional installed sensors are required onboard. The method can be made non-intrusive through use of a portable (i.e., not permanently installed) monitoring device for measuring and assessing **EM** emissions. The methods above can be applied to monitor the health of any type of power converter irrespective of its configuration and design. The methods are computationally relatively simple, requiring only the assessment of certain selected frequencies in **EM** emissions. Monitoring in this way can provide a more accurate and less complex way of assessing the health of converters in a propulsion system compared to other techniques. A further advantage is that the methods can be employed on ground as part of a pre-flight check, which can improve safety by determining the health of the converters.

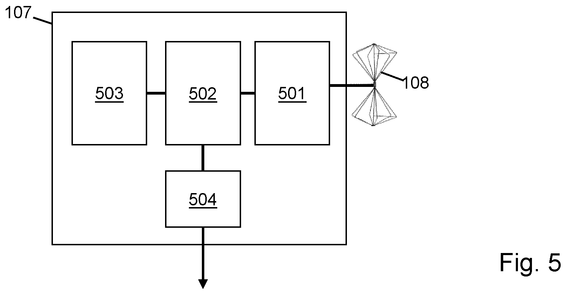

Figure 5 is a schematic diagram of an example portable monitor 107 for assessing a power electronics converter. The monitor 107 comprises an antenna 108 for receiving electromagnetic emissions from the converter, i.e., one or both of the converters 102₁, 102₂ described above. An antenna interface 501 receives EM emission signals from the antenna 108 and provides the signals to a processor 502. The processor 502 records the EM signals in a memory 503 and compared the recorded signals with a second set of signals, which may be also recorded in memory 503. The monitor 107 further comprises an input/output interface 504 for connecting to a remote computer network, for example in the form of a wired or wireless interface enabling the monitor 107 to connect to the internet. The input/output interface 504 may also allow the monitor 107 to provide control signals to the controllers 204₁, 204₂ of the propulsion system 100 to control an assessment routine as described above. In use, the monitor 107 may be positioned with a single antenna 108 at an equal distance from each converter in the electric propulsion system or the monitor may comprise two antennae that can be positioned at equal distances from a respective converter. In either case a comparable magnitude of electromagnetic emissions can be received from the converters.

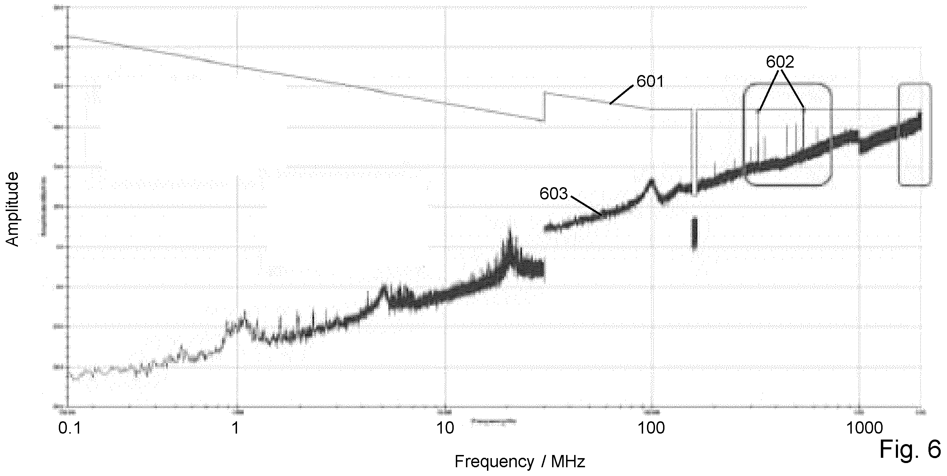

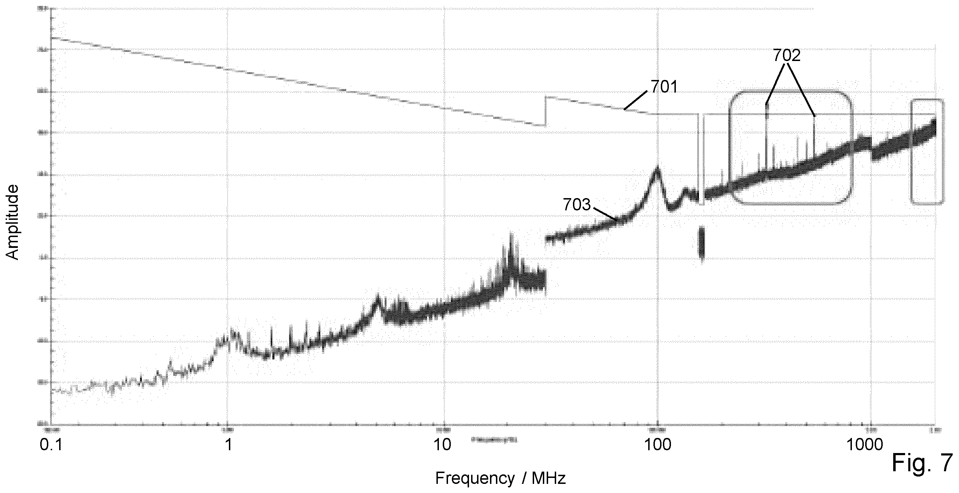

Figures 6 and 7 illustrate example plots of electromagnetic emission as a function of frequency covering a range from 150 kHz to 2 GHz. In each case, a predetermined limit 601, 701 is defined across the frequency range, indicating the maximum permissible emission limit above which a fault may be detected. Peaks 602, 702 in the electromagnetic noise spectrum 603, 703 at selected frequencies are compared to the predetermined limit 601, 701 at those frequencies to determine a fault. In both examples, emission peaks are detected at around 324 and 540 MHz, with the example in Figure 7 showing a peak at 324 MHz exceeding the limit 701 indicating a possible fault in the converter. Peaks in emissions at frequencies above around 1 GHz are less distinguishable from ambient noise and are therefore not considered to be from the device under test. In a general aspect, analysis may be performed within a frequency range of between around 100 and 1000 MHz, for example in a range between around 200 and 800 MHz.

Various examples have been described, each of which comprise one or more combinations of features. It will be appreciated by those skilled in the art that, except where clearly mutually exclusive, any of the features may be employed separately or in combination with any other features and the invention extends to and includes all combinations and sub-combinations of one or more features described herein.

## Claims

1. A method of assessing a power electronics converter (102₁, 102₂) in an electrical propulsion system (100), the power electronics converter (102₁, 102₂) connected between a DC power supply (103₁, 103₂) and an AC electrical machine (101₁, 101₂) connected to a rotatable mechanical load (105, 203), the method comprising:
i) operating the converter (102₁, 102₂) to drive the electrical machine (101₁, 101₂) to apply a torque to the mechanical load (105, 203);
ii) recording a first set of electromagnetic emissions from the converter (102₁, 102₂);
iii) comparing the first set of electromagnetic emissions with a second set of electromagnetic emissions to determine a difference between the first and second set of electromagnetic emissions; and
iv) providing an assessment of the converter (102₁, 102₂) based on the difference between the first and second sets of electromagnetic emissions.

2. The method of claim 1, wherein the second set of electromagnetic emissions is a pre-recorded set of electromagnetic emissions from a nominal power electronics converter.

3. The method of claim 1 or claim 2, wherein the assessment indicates a fault in the power electronics converter (102₁, 102₂) if the determined difference is greater than a predetermined level.

4. The method of claim 1, wherein the power electronics converter (102₁, 102₂) is a first power electronics converter (102₁), the AC electrical machine (101₁, 101₂) is a first AC electrical machine (101₁) and the DC power supply (103₁, 103₂) is a first DC power supply (103₁), the electrical propulsion system (100) further comprising a second power electronics converter (102₂) connected between the second DC power supply (103₂) and the second AC electrical machine (101₂), the second AC electrical machine (101₂) connected to the rotatable mechanical load (105, 203), wherein step i) comprises operating both first and second power electronics converters (102₁, 102₂) to drive the respective first and second electrical machines (101₁, 101₂) with equal and opposing torques (+T, -T).

5. The method of claim 4, comprising recording the second set of electromagnetic emissions from the second power electronics converter (102₂).

6. The method of any preceding claim, wherein step iii) comprises comparing a magnitude of emissions in a plurality of frequency bands in the first and second sets of electromagnetic emissions.

7. The method of claim 6, wherein the assessment in step iv) indicates a fault in the first power electronics converter (102₁) if the magnitude of emissions in one or more of the plurality of frequency bands is greater in the first set of electromagnetic emissions by more than a predetermined threshold.

8. The method of any preceding claim, wherein the assessment in step iv) comprises an indication of remaining useful life of the power electronics converter (102₁, 102₂).

9. The method of any preceding claim, wherein steps ii) to iv) are carried out by a portable monitoring device (107) comprising an antenna (108) configured to receive the electromagnetic emissions (106) from the converter (102₁, 102₂).

10. A monitoring device (107) for assessing a power electronics converter (102₁, 102₂) in an electrical propulsion system (100), the power electronics converter (102₁, 102₂) connected between a DC power supply (103₁, 103₂) and an AC electrical machine (101₁, 101₂) connected to a rotatable mechanical load (105, 203), the monitoring device (107) comprising an antenna (108) arranged to receive electromagnetic emissions from the power electronics converter (102₁, 102₂), the monitoring device (107) configured to:
i) record a first set of electromagnetic emissions from the converter (102₁, 102₂) via the antenna (108) during operation of the electrical propulsion system (100);
ii) compare the first set of electromagnetic emissions with a second set of electromagnetic emissions to determine a difference between the first and second set of electromagnetic emissions; and
iii) provide an assessment of the converter (102₁, 102₂) based on the difference between the first and second sets of electromagnetic emissions.

11. The monitoring device (107) of claim 10, wherein the second set of electromagnetic emissions is a pre-recorded set of electromagnetic emissions from a nominal power electronics converter.

12. The monitoring device (107) of claim 10 or claim 11, wherein the assessment indicates a fault in the power electronics converter (102₁, 102₂) if the determined difference is greater than a predetermined level.

13. The monitoring device (107) of claim 10, wherein the power electronics converter (102₁, 102₂) is a first power electronics converter (102₁), the AC electrical machine (101₁, 101₂) is a first AC electrical machine (101₁) and the DC power supply (103₁, 103₂) is a first DC power supply (103₁), the electrical propulsion system (100) further comprising a second power electronics converter (102₂) connected between the second DC power supply (103₂) and the second AC electrical machine (101₂), the second AC electrical machine (101₂) connected to the rotatable mechanical load (105, 203), wherein step i) comprises operating both first and second power electronics converters (102₁, 102₂) to drive the respective first and second electrical machines (101₁, 101₂) with equal and opposing torques (+T, -T).

14. The monitoring device (107) of claim 13, wherein the monitoring device (107) is configured to record the second set of electromagnetic emissions from the second power electronics converter (102₂).

15. The monitoring device (107) of any one of claims 10 to 14, wherein the monitoring device (107) is configured to compare a magnitude of emissions in a plurality of frequency bands in the first and second sets of electromagnetic emissions.
